# EUROPEAN PATENT APPLICATION

(11) **EP 4 823 297 A2**
(43) Date of publication of application: **14.10.2026**
(21) Application number: 26201981.3
(22) Date of filing: 31.08.2026
(51) Int. Cl.: H10K 59/126

(54) **DISPLAY PANEL AND DISPLAY DEVICE**

(30) Priority: 27.04.2026 CN 202610563762
(71) Applicant: Wuhan China Star Optoelectronics Semiconductor Display Technology Co., Ltd., Wuhan, Hubei 430079 (CN)
(72) Inventor: WU, Rusong, Wuhan 430079 (CN); YAN, Longfei, Wuhan 430079 (CN); YU, Haijun, Wuhan 430079 (CN)
(74) Representative: Studio Torta S.p.A.

(57) **Abstract**

A display panel and a display device are provided. The display panel includes a substrate; a light-emitting layer, a first light-shielding layer, and a second light-shielding layer that are disposed on one side of the substrate. The light-emitting layer has a first pixel area and a second pixel area arranged adjacent to each other along a first direction, and includes a plurality of first sub-pixels located in the first pixel area and a plurality of second sub-pixels located in the second pixel area. The first light-shielding layer includes a first opening corresponding to the first sub-pixel and a second opening corresponding to the second sub-pixel. The second light-shielding layer covers part of the second pixel area and includes a third opening corresponding to the second opening. A distance between the first sub-pixel and the second sub-pixel adjacent to each other along the first direction is greater than at least one of a distance in the first direction between two adjacent first sub-pixels along the first direction and a distance in the first direction between two adjacent second sub-pixels along the first direction. The invention can improve symmetry of viewing angles of emitted light from the first pixel area.

## Description

### TECHNICAL FIELD

The invention relates to the field of display technologies, and in particular, to a display panel and a display device.

### BACKGROUND

Organic light-emitting diodes (OLED) have high light-emitting efficiency and fast response speed, which can be produced in flexible substrates and are favored by the users due to their advantages such as resistance to bending and wide viewing angles, and are widely used in products like small and medium-sized displays and wearables. With the development of science and technology, as well as improvement of living standards, monitoring and management of health functions by products such as smartwatches are becoming more popular with users. At the same time, requirements for advanced feeling, technological feeling and aesthetic feeling on display function experience are also increasing. Users (especially business people) have high privacy requirements when using mobile phones, tablets, or laptops for work in public places. Therefore, in recent years, the development of anti-peeping screens has gradually increased.

In the conventional anti-peeping screen, light from a large viewing angle is shielded by designing a light-shielding layer (for example, a black matrix BM) above the pixel to achieve anti-peeping effect. In the non-anti-peeping mode, however, light from a large viewing angle may be retained by increasing the outward expansion amount of the BM relative to the pixel opening so as to switch between the anti-peeping mode and the shared mode. However, the current anti-peeping screen has a problem of asymmetry in viewing angles of emitted light of the OLED in non-anti-peeping mode.

### SUMMARY

Embodiments of the invention provide a display panel and a display device, which can improve symmetrical performance in viewing angles of emitted light in the shared display mode on the basis of switching between the display mode and the shared display mode.

In order to achieve the above object, according to a first aspect of the invention, a display panel is provided, including:
a substrate;
a light-emitting layer located on one side of the substrate and having at least one first pixel area and at least one second pixel area adjacent to each other along a first direction; wherein the light-emitting layer includes a plurality of first sub-pixels located in the first pixel area and a plurality of second sub-pixels located in the second pixel area;
a first light-shielding layer located on one side of the light-emitting layer facing away from the substrate, and provided with at least one first opening and at least one second opening, wherein the first opening is disposed corresponding to at least one of the first sub-pixels, and the second opening is disposed corresponding to at least one of the second sub-pixels; and
a second light-shielding layer located on one side of the first light-shielding layer facing away from the substrate, wherein the second light-emitting layer coveris part of the second pixel area, and includes at least one third opening corresponding to the second opening;
wherein a distance in the first direction between one of the first sub-pixels and one of the second sub-pixels adjacent to each other in the first direction is greater than at least one of a distance in the first direction between two adjacent ones of the first sub-pixels in the first direction and a distance in the first direction between two adjacent ones of the second sub-pixels in the first direction.

Optionally, the distance in the first direction between the two adjacent first sub-pixels in the first direction and/or the distance in the first direction between the two adjacent second sub-pixels in the first direction is d1; the distance in the first direction between the first sub-pixel and the second sub-pixel adjacent to each other in the first direction is d2; a width of one of the first sub-pixels adjacent to one of the second sub-pixels in the first direction or a width of one of the second sub-pixels adjacent to one of the first sub-pixels in the first direction is d3; wherein d1, d2, and d3 satisfy a relationship of d2-d1≤d3.

Optionally, d1 and d2satisfy a relationship of d2-d1≤15µm.

Optionally, a difference between maximum viewing angles of emitted light from two opposite sides in the first direction of one of the first sub-pixels adjacent to one of the second sub-pixels in the first direction ranges from 0° to 30°.

Optionally, the first light-shielding layer further includes a first light-shielding portion located between the first opening and the second opening adjacent to each other in the first direction; and the second light-shielding layer further includes a second light-shielding portion overlapped with the first light-shielding portion along a thickness direction of the substrate; and
wherein a side of the first sub-pixel that is adjacent to the second sub-pixel in the first direction away from the substrate has a light-emitting center; and a virtual surface passing through the light-emitting center and an edge of the first light-shielding portion close to an adjacent first opening is defined as a reference plane, wherein the second light-shielding portion is located at a side of the reference plane facing an adjacent second opening.

Optionally, the first light-shielding layer further includes a first light-shielding portion located between the first opening and the second opening adjacent to each other in the first direction; and the second light-shielding layer further includes a second light-shielding portion overlapped with the first light-shielding portion along a thickness direction of the substrate; and
wherein a width of the first light-shielding portion in the first direction is greater than a width of the second light-shielding portion in the first direction.

Optionally, the display panel further includes a pixel definition layer located on the substrate, the pixel definition layer includes a plurality of first pixel openings located in the first pixel area, a plurality of second pixel openings located in the second pixel area, and a plurality of blocking walls disposed around the first pixel openings and the second pixel openings; wherein each of the first sub-pixels is located in each of the first pixel openings, and each of the second sub-pixels is located in each of the second pixel openings; and
wherein one of the blocking walls includes a first blocking wall portion located between one of the first sub-pixels and one of the second sub-pixels adjacent to each other, an orthographic projection of the first light-shielding portion on the substrate is located within an orthographic projection of the first blocking wall portion on the substrate, and an orthographic projection of the second light-shielding portion on the substrate is located within an orthographic projection of the first light-shielding portion on the substrate.

Optionally, a distance between a side of the first light-shielding portion close to an adjacent one of the first sub-pixels and a side of the first blocking wall portion close to the adjacent one of the first sub-pixels in the first direction is greater than a distance between a side of the first light-shielding portion close to an adjacent one of the second sub-pixels and a side of the first blocking wall portion close to the adjacent one of the second sub-pixels in the first direction; and
wherein a distance between a side of the second light-shielding portion close to an adjacent one of the first sub-pixels and a side of the first blocking wall portion close to the adjacent one of the first sub-pixels in the first direction is greater than a distance between a side of the second light-shielding portion close to an adjacent one of the second sub-pixels and a side of the first blocking wall portion close to the adjacent one of the second sub-pixels in the first direction.

Optionally, a distance between a side of the second light-shielding portion close to an adjacent one of the first sub-pixels and a side of the first light-shielding portion close to the adjacent one of the first sub-pixels in the first direction is greater than a distance between a side of the second light-shielding portion close to an adjacent one of the second sub-pixels and a side of the first light-shielding portion close to the adjacent one of the second sub-pixels in the first direction.

Optionally, the side of the second light-shielding portion close to the adjacent second sub-pixel and the side of the first light-shielding portion close to the adjacent second sub-pixel are disposed in alignment with each other in the thickness direction of the substrate.

Optionally, the first light-shielding portion and the second light-shielding portion extend along a second direction, and/or the first light-shielding portion and the second light-shielding portion are both distributed in a shape of strip along a second direction; wherein the first direction is perpendicular to the second direction.

Optionally, the first light-shielding layer further includes a third light-shielding portion located between two adjacent ones of at least two first openings in the first direction, the third light-shielding portion extends along the second direction, and a width of the in the third light-shielding portion in the first direction is smaller than the width of the first light-shielding portion in the first direction.

Optionally, the first light-shielding layer further includes a fourth light-shielding portion located between the two adjacent ones of at least two second openings in the first direction, the fourth light-shielding portion extends along the second direction, and the width of the in the third light-shielding portion in the first direction is smaller than a width of the fourth light-shielding portion in the first direction.

Optionally, the second light-shielding layer further includes a fifth light-shielding portion located between two adjacent ones of at least two third openings in the first direction, the fifth light-shielding portion extends along the second direction, and a width of the in the fifth light-shielding portion in the first direction is greater than a width of the second light-shielding portion in the first direction.

Optionally, the light-emitting layer includes a plurality of first pixel areas and a plurality of second pixel areas; the first pixel areas and the second pixel areas are alternately arranged in the first direction; and the first pixel areas and the second pixel areas are alternately arranged in a second direction perpendicular to the first direction; and
two first light-shielding portions disposed adjacent to each other in the second direction are connected with each other, and two second light-shielding portions disposed adjacent to each other in the second direction are connected with each other.

Optionally, the first light-shielding layer further includes at least one first connecting portion, and the second light-shielding layer further includes at least one second connecting portion; and
wherein the two first light-shielding portions adjacent to each other in the second direction are connected by one first connecting portion, and the two second light-shielding portions adjacent to each other in the second direction are connected by one second connecting portion, wherein an included angle between the first connecting portion and the second direction is greater than 0°, and an included angle between the second connecting portion and the second direction is greater than 0°.

Optionally, an orthographic projection of one of the first sub-pixels on the substrate is located in an orthographic projection of a corresponding first opening on the substrate, and the first opening includes a first sidewall and a second sidewall disposed opposite to each other along the first direction, wherein a distance between an orthographic projection of the first sidewall on the substrate and an orthographic projection of a corresponding one of the first sub-pixels on the substrate in the first direction is equal to a distance between an orthographic projection of the second sidewall on the substrate and an orthographic projection of the corresponding first sub-pixel on the substrate in the first direction; and/or
wherein an orthographic projection of one of the second sub-pixels on the substrate is located in an orthographic projection of the second opening on the substrate, and the second opening includes a third sidewall and a fourth sidewall disposed opposite to each other along the first direction, wherein a distance between an orthographic projection of the third sidewall on the substrate and an orthographic projection of a corresponding one of the second sub-pixels on the substrate in the first direction is equal to a distance between an orthographic projection of the fourth sidewall on the substrate and an orthographic projection of the corresponding second sub-pixel on the substrate in the first direction; and/or
wherein an orthographic projection of one of the second sub-pixels on the substrate is located in an orthographic projection of the third opening on the substrate, and the third opening includes a fifth sidewall and a sixth sidewall disposed opposite to each other along the first direction, wherein a distance between an orthographic projection of the fifth sidewall on the substrate and an orthographic projection of a corresponding one of the second sub-pixels on the substrate in the first direction is equal to a distance between an orthographic projection of the sixth sidewall on the substrate and an orthographic projection of the corresponding second sub-pixel on the substrate in the first direction.

Optionally, the plurality of first sub-pixels in the first pixel area include a first-color sub-pixel, a second-color sub-pixel and a third-color sub-pixel; and the plurality of second sub-pixels in the second pixel area include the first-color sub-pixel, the second-color sub-pixel and the third-color sub-pixel; and
in the first pixel area and the second pixel area adjacent to each other along the first direction, the third-color sub-pixel in the first pixel area is located at a side of the first-color sub-pixel and the second-color sub-pixel in the first pixel area close to the second pixel area; and the third-color sub-pixel in the second pixel area is located at a side of the first-color sub-pixel and the second-color sub-pixel in the second pixel area away from the first pixel area.

Optionally, in a same first pixel area, the first-color sub-pixel and the second-color sub-pixel are exposed by a same one of at least two first openings, and the third-color sub-pixel is exposed by another one of the at least two first openings; and
wherein in a same second pixel area, the first-color sub-pixel and the second-color sub-pixel are exposed by a same one of at least two second openings, and the third-color sub-pixel is exposed by another one of the at least two second openings.

In a second aspect of the invention, a display device is provided, the display device includes the display panel in any one of the embodiments described above.

In the display panel and the display device of the embodiments of the invention, on one hand, by providing the first light-shielding layer and the second light-shielding layer, light of large viewing angle emitted from the first sub-pixel and the second sub-pixel is shielded by the first light-shielding layer, and light of small viewing angle emitted from the first sub-pixel is not shielded by the second light-shielding layer, but the light of small viewing angle emitted from the second sub-pixel is shielded by the second light-shielding layer. As such, at least in two opposite sides of the display panel along the first direction, the maximum viewing angle of emitted light of the first sub-pixel through the first opening is greater than the maximum viewing angle of emitted light of the second sub-pixel through the second opening and the third opening. Thus, it is possible to switch between the anti-peeping display mode and the shared display mode by controlling working states of the first sub-pixel and the second sub-pixel.

On the other hand, the distance in the first direction between the first sub-pixel and the second sub-pixel adjacent to each other in the first direction is designed differently from the distance in the first direction of two adjacent sub-pixels of a same type (anti-peeping or non-anti-peeping) in the first direction, and the distance between the first sub-pixel and the second sub-pixel adjacent to each other in the first direction is increased, which facilitates disposing the second light-shielding layer away from the first sub-pixel further, thereby reducing the shielding amount of emitted light of the first sub-pixel through the first opening by the second light-shielding layer, or preventing the emitted light of the first sub-pixel through the first opening from being shielded by the second light-shielding layer, so as to improve symmetry of viewing angles of emitted light from the first sub-pixel.

Therefore, the invention can improve symmetrical performance in viewing angles of emitted light in the shared display mode on the basis of switching between the display mode and the shared display mode.

Other features and advantages of the invention will be described in detail in the following detailed description.

### BRIEF DESCRIPTION OF THE DRAWINGS

In order to explain the technical solutions in the embodiments of the invention more clearly, the accompanying drawings required in the description of the embodiments will be briefly introduced below. It is evident that the accompanying drawings in the following description are merely some of the embodiments of the invention, and other drawings may be obtained on the basis of these drawings for those skilled in the art without involving any inventive effort.

For a more complete understanding of the invention and its beneficial effects, the following description will be made in combination with the accompanying drawings, and the same reference numerals refer to the same parts in the following description.
FIG. 1 is a schematic diagram of a partial cross-sectional structure of an exemplary display panel according to some embodiments of the invention;
FIG. 2 is a schematic diagram of a partial cross-sectional structure of a display panel according to some embodiments of the invention;
FIG. 3 is a schematic diagram of a partial top viewing structure of a display panel according to some embodiments of the invention;
FIG. 4 is a schematic diagram of another partial top viewing structure of a display panel according to some embodiments of the invention;
FIG. 5 is a schematic diagram of a partial cross-sectional structure of another exemplary display panel according to some embodiments of the invention;
FIG. 6 is a schematic diagram of azimuth angles of a display panel according to some embodiments of the invention;
FIG. 7 is a u'v' chromaticity diagram of a first sub-pixel adjacent to a second sub-pixel in FIG. 5; and
FIG. 8 is a schematic diagram of a partial cross-sectional structure of a display device according to some embodiments of the invention.

### Description of reference numerals:

100 (100')-Display Panel; 1-Substrate; 2 (2')-Pixel Definition Layer; 3-Pixel Layer; 4-Encapsulation Layer; 4a-First Inorganic Encapsulation Layer; 4b-Organic Encapsulation Layer; 4c-Second Inorganic Encapsulation Layer; 5-Touch Layer; 6-Optical Covering Layer; 7-Light-Shielding Layer; 8-Protective Layer; 9-Anti-Peeping Area; 10, Non-Anti-Peeping Area; 11 (11')-First Pixel Opening; 12 (12')-Second Pixel Opening; 13-Light Transmission Opening; 14-Light-Emitting Layer; 15-First Light-Shielding Layer; 15a-First Light-Shielding Portion; 15b-Third Light-Shielding Portion; 15c-Fourth Light-Shielding Portion; 15d-First Connecting Portion; 16-Second Light-Shielding Layer; 16a-Second Light-Shielding Portion; 16b-Fifth Light-Shielding Portion; 16c-Second Connecting Portion; 17-First Pixel Area; 18-Second Pixel Area; 19-First Sub-Pixel; 20-Second Sub-Pixel; 21-First Opening; 21a-First Sidewall; 21b-Second Sidewall; 22-Second Opening; 22a-Third Sidewall; 22b-Fourth Sidewall; 23-Third Opening; 23a-Fifth Sidewall; 23b-Sixth Sidewall; 24-Blocking Wall; 24a-First Blocking Wall Portion; 25-First-Color Sub-Pixel; 26-Second-Color Sub-Pixel; 27-Third-Color Sub-Pixel;
200-Display Device; 28-Housing;
X-First direction; Y-Second direction; Z-Thickness direction.

### DETAILED DESCRIPTION

In the following, the solutions in the embodiments of the invention will be clearly and completely described with reference to the accompanying drawings. It is evident that the described embodiments are only part, rather than all, of the embodiments of the invention. Based on the embodiments in the invention, all other embodiments obtained by those skilled in the art without involving any inventive effort are within the scope of the invention.

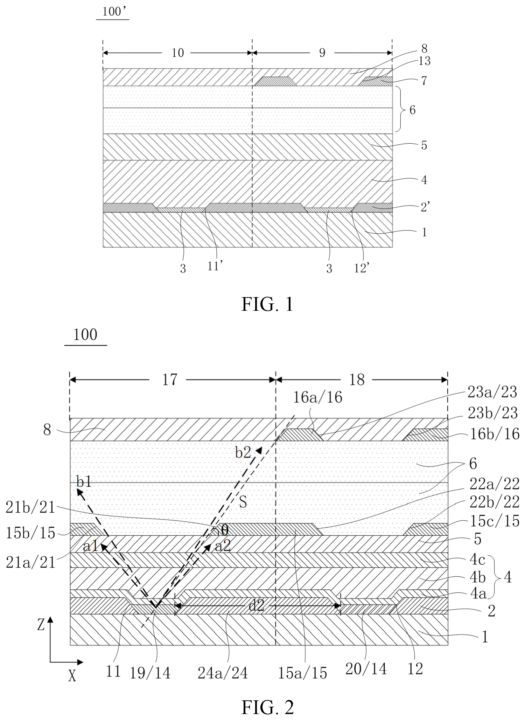

As shown in FIG. 1, an exemplary display panel 100' having anti-peeping effect includes a substrate 1, a pixel definition layer 2', a pixel layer 3, an encapsulation layer 4, a touch layer 5, an optical covering layer 6, a light-shielding layer 7 and a protective layer 8 from bottom to top sequentially. The display panel 100' includes an anti-peeping area 9 and a non-anti-peeping area 10, and the light-shielding layer 7 covers only part of the anti-peeping area 9. The pixel definition layer 2' includes a first pixel opening 11' located in the non-anti-peeping area 10 and a second pixel opening 12' located in the anti-peeping area 9, and the light-shielding layer 7 is provided with a light transmission opening 13 corresponding to the second pixel opening 12'. The light-shielding layer 7 can shield the light of large viewing angle emitted by the pixel layer 3 in the second pixel opening 12', so that the pixel layer 3 in the second pixel opening 12' has a small viewing angle of emitted light, thereby achieving an anti-peeping display effect. Moreover, the outward expansion amount of the light-shielding layer 7 relative to the first pixel opening 11' is increased, so as to avoid shielding the light of large viewing angle emitted from the pixel layer 3 located in the first pixel opening 11', thereby achieving a shared display effect.

It should be noted that the outward expansion amount of the light-shielding layer 7 relative to the first pixel opening 11' refers to a distance between an orthographic projection of the light-shielding layer 7 on the substrate 1 and an orthographic projection of the first pixel opening 11' on the substrate 1. When the outward expansion amount is greater than 0, the orthographic projections thereof are not overlapped; and when the outward expansion amount is less than 0, the orthographic projections thereof are overlapped.

It can be understood that the pixel layer 3 located in the first pixel opening 11' belongs to the non-anti-peeping pixel, and the pixel layer 3 located in the second pixel opening 12' belongs to the anti-peeping pixel. The switching between the anti-peeping display mode and the non-anti-peeping display mode may be realized by controlling the switching of working states between the anti-peeping pixel and the non-anti-peeping pixel.

However, with the increase of pixel resolution (Pixels Per Inch, PPI) of the display panel 100', the distance between adjacent pixels is limited. Light emitted from a side away from the light-shielding layer 7 of the non-anti-peeping pixel adjacent to the anti-peeping pixel is not affected by the light-shielding effect of the light-shielding layer 7; however, light emitted from a side close to the light-shielding layer 7 of the non-anti-peeping pixel adjacent to anti-peeping pixel inevitably suffers from the light-shielding effect of the light-shielding layer 7, which enables the viewing angles of emitted light from the non-anti-peeping pixel adjacent to the anti-peeping pixel to be asymmetric, thereby affecting the display performance of the display panel 100'.

Therefore, in the embodiments of the invention provide a display panel and display device, another light-shielding layer is added between the light-shielding layer and the pixel layer shown in FIG. 1, so that light of large viewing angle emitted by the non-anti-peeping pixel can be symmetrically shielded by the first light-shielding layer that is closer, and light of small viewing angle emitted by the non-anti-peeping pixel is not shielded by the second light-shielding layer that is farther away, thereby improving the symmetry of viewing angles of the non-anti-peeping pixel. Furthermore, in the embodiments of the invention, the distance between adjacent anti-peeping pixel and non-anti-peeping pixel is differentiated from the distance between other pixels of the same type (anti-peeping pixel or non-anti-peeping pixel), which can further ensure that light emitted by the non-anti-peeping pixel through the opening of the first light-shielding layer is not shielded by the second light-shielding layer that is farther away, without changing the opening size of the first light-shielding layer and the width of the second light-shielding layer, thereby improving symmetry of viewing angles of emitted light from the non-anti-peeping area.

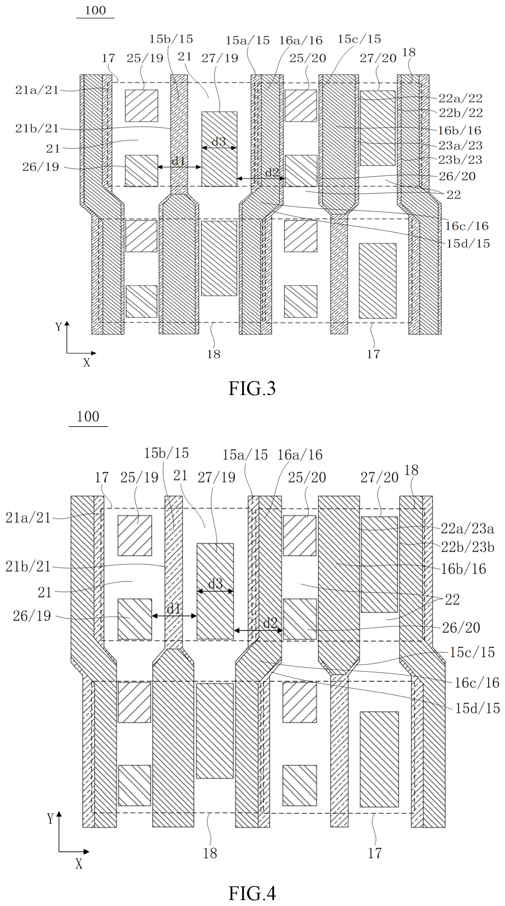

As shown in FIG. 2 and FIG. 3, the invention provides a display panel 100, the display panel 100 includes a substrate 1, and a light-emitting layer 14, a first light-shielding layer 15 and a second light-shielding layer 16 that are disposed on one side of the substrate 1. The light-emitting layer 14 is located at one side of the substrate 1, and has a first pixel area 17 and a second pixel area 18 adjacent to each other along a first direction X. The light-emitting layer 14 includes a plurality of first sub-pixels 19 located in the first pixel area 17 and a plurality of second sub-pixels 20 located in the second pixel area 18. The first light-shielding layer 15 is disposed on a side of the light-emitting layer 14 facing away from the substrate 1, and is provided with at least one first opening 21 and at least one second opening 22. The first opening 21 is disposed corresponding to at least one first sub-pixel 19, and the second opening 22 is disposed corresponding to at least one second sub-pixel 20. The second light-shielding layer 16 is located at a side of the first light-shielding layer 15 facing away from the substrate 1, covers part of the second pixel area 18, and includes at least one third opening 23 corresponding to at least one second opening 22.

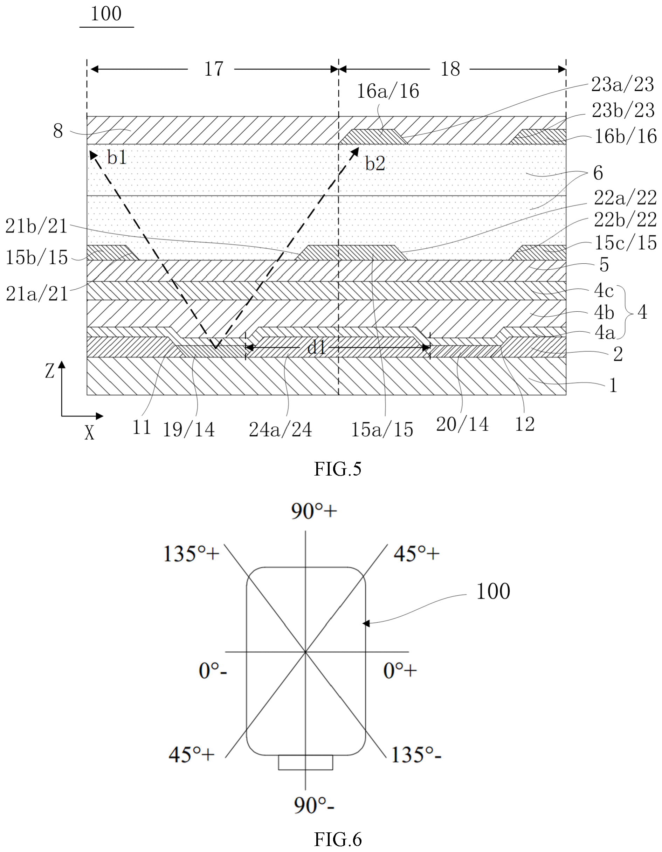

The distance in the first direction X (for example, d2 in FIG. 2 or FIG. 3) between the first sub-pixel 19 and the second sub-pixel 20 adjacent to each other along the first direction X is greater than at least one of the distance in the first direction X (for example, d1 in FIG. 3 or FIG. 5) between two adjacent first sub-pixels 19 along the first direction X and the distance in the first direction X between two adjacent second sub-pixels 20 along the first direction X.

In some embodiments, the substrate 1 may be an array substrate. For example, the substrate 1 includes a substrate layer and a driving circuit layer (not shown in the figures) disposed on the substrate layer. The driving circuit layer is electrically connected with the first sub-pixel 19 and the second sub-pixel 20 in the light-emitting layer 14 to drive the first sub-pixel 19 and the second sub-pixel 20 to emit light.

In some embodiments, the substrate layer may be a flexible substrate or a rigid substrate, which is not limited herein.

It should be noted that, the specific structure of the substrate is not limited in the embodiments of the invention, and the driving manner of the first sub-pixel 19 and the second sub-pixel 20 is not limited herein.

In some embodiments, the first sub-pixel 19 and the second sub-pixel 20 may emit light independently. Therefore, when the first sub-pixel 19 emits light, the second sub-pixel 20 may or may not emit light. Similarly, when the second sub-pixel 20 emits light, the first sub-pixel 19 may or may not emit light, which is not limited in the invention.

It can be understood that the plurality of first sub-pixels 19 in the first pixel area 17 may emit light with different colors respectively, or some of the first sub-pixels 19 or all the first sub-pixels 19 emit light with a same color. Similarly, the plurality of second sub-pixels 20 in the second pixel area 18 may emit light with different colors respectively, or some or all of the second sub-pixels 20 may emit light with a same color. Moreover, the plurality of first sub-pixels 19 in the first pixel area 17 are arranged at intervals from each other, and the plurality of second sub-pixels 20 in the second pixel area 18 are also arranged at intervals from each other.

It should be noted that the first light-shielding layer 15 covers a part of the first pixel area 17 and a part of the second pixel area 18, while the second light-shielding layer 16 only covers a part of the second pixel area 18. Part of the light emitted by the first sub-pixel 19 may be emitted through a corresponding first opening 21 for display, and part of the light emitted by the second sub-pixel 20 may be emitted through a corresponding second opening 22 and a third opening 23 for display.

Specifically, as shown in FIG. 2, the light a1 and light a2 both with large viewing angles emitted by the first sub-pixel 19 can be shielded by the first light-shielding layer 15 located at the periphery of the first opening 21. By adjusting the positional relationship between the first opening 21 and the first sub-pixel 19, the large-viewing-angle light a1 and a2 emitted by the first sub-pixel 19 can be symmetrically shielded by the first light-shielding layer 15.In addition, by adjusting the outward expansion amount of the second light-shielding layer 16 relative to the first sub-pixel 19, the light b1 and light b2 emitted by the first sub-pixel 19 through the first opening 21 will not be shielded by the second light-shielding layer 16, or the amount of light emitted by the first sub-pixel 19 through the first opening 21 shielded by the second light-shielding layer 16 is reduced, so as to improve the symmetry of viewing angles of emitted light from the first sub-pixel 19 disposed close to the second sub-pixel 20 can be improved.

It should be noted that the outward expansion amount of the second light-shielding layer 16 with respect to the first sub-pixel 19 refers to the distance between an orthographic projection of the second light-shielding layer 16 on the substrate 1 and an orthographic projection of the first sub-pixel 19 on the substrate 1. When the outward expansion amount is greater than 0, the second light-shielding layer 16 and the first sub-pixel 19 are not overlapped in a thickness direction Z of the substrate 1; when the outward expansion amount is less than 0, the second light-shielding layer 16 and the first sub-pixel 19 are overlapped in the thickness direction Z of the substrate 1.

Specifically, the light with a large viewing angle emitted by the second sub-pixel 20 are shielded by the first light-shielding layer 15 located at an outer periphery of the second opening 22, and the light with a small viewing angle emitted by the second sub-pixel 20 are shielded by the second light-shielding layer 16 located at an outer periphery of the third opening 23. Thus, the second sub-pixel 20 has relatively small viewing angles of emitted light. Therefore, the maximum viewing angle of light emitted from the second sub-pixel 20 through the second opening 22 and the third opening 23 is smaller than the maximum viewing angle of light emitted from the first sub-pixel 19 through the first opening 21.

Specifically, the display panel 100 has an anti-peeping display mode and a non-anti-peeping display mode, and the non-anti-peeping display mode is also referred to as a shared display mode. In the anti-peeping display mode, the first sub-pixels 19 in the first pixel area 17 do not emit light, and the second sub-pixels 20 in the second pixel area 18 emit light. In this case, the second sub-pixels 20 have relatively small viewing angles of emitted light to achieve an anti-peeping effect. For example, the anti-peeping effect can be achieved at least on two opposite sides of the display panel 100 along the first direction X. In the shared display mode, both the first sub-pixels 19 in the first pixel area 17 and the second sub-pixels 20 in the second pixel area 18 emit light, or only the first sub-pixels 19 in the first pixel area 17 emit light, so that a shared display effect can be achieved.

It can be understood that the first sub-pixels 19 in the embodiments of the invention may serve as non-anti-peeping pixels, and the second sub-pixels 20 may serve as anti-peeping pixels, which is not limited thereto.

In order to improve the PPI of the display panel, distances between the sub-pixels in the anti-peeping areas and sub-pixels in the non-anti-peeping area along the first direction X are generally kept consistent, which leads to a small distance between adjacent anti-peeping pixel and non-anti-peeping pixel.

For example, as shown in FIG. 5, according to the conventional design, the distance d1 between adjacent first sub-pixel 19 and second sub-pixel 20 in the first direction X is the same as the distance between two adjacent first sub-pixels 19 in the first direction X and the same as the distance between two adjacent second sub-pixels 20 in the first direction X, however, an increase of PPI of the panel leads to a relatively small distance between adjacent first sub-pixel 19 and second sub-pixel 20 in the first direction X. The design limits the increasing range of the outward expansion amount of the second light-shielding layer 16 relative to the first sub-pixel 19. In the case where the outward expansion amount of the first light-shielding layer 15 relative to the first sub-pixel 19 remains unchanged, light b2 at a side of the first sub-pixel 19 close to the second light-shielding layer 16 is shielded by the second light-shielding layer 16, which leads to a poor symmetry of white angular dependency (WAD) of the first pixel area 17, and thereby affecting the display effect in the shared display mode.

It should be noted that, WAD refers to the changing degree in brightness and chromaticity as the viewing angle changes when a white color is displayed; WAD symmetry refers to the consistent and symmetrical pattern of brightness attenuation and color deviation (bluish/pinkish) of a panel at large viewing angles under horizontal/vertical, left-right/up-down directions.

In order to improve the WAD symmetry or symmetry of viewing angle of the first pixel area 17, in this embodiments of the invention, a differential design is made for the distances between sub-pixels at different positions along the first direction X. Specifically, as shown in FIG. 2, in some embodiments of the invention, the distance in the first direction between adjacent first sub-pixel 19 and second sub-pixel 20 in the first direction X is increased.

Specifically, the first light-shielding layer 15 further includes a first light-shielding portion 15a located between adjacent first opening 21 and second opening 22. The second light-shielding layer 16 further includes a second light-shielding portion 16a overlapped with the first light-shielding portion 15a in the thickness direction Z of the substrate 1. It can be understood that the first light-shielding portion 15a and the second light-shielding portion 16a are arranged corresponding to an area between adjacent first sub-pixel 19 and second sub-pixel 20 in the first direction X.

Compared with the distance d1 between the first sub-pixel 19 and the second sub-pixel 20 adjacent to each other in the first direction X shown in FIG. 5, according to some embodiments of the invention, the distance between the first sub-pixel 19 and the second sub-pixel 20 adjacent to each other in the first direction X is increased from d1 to d2 (d2>d1), so that in the case where the outward expansion amount of the first light-shielding portion 15a relative to the first sub-pixel 19 is unchanged and the width of the second light-shielding portion 16a in the first direction X is unchanged, the distance between the second light-shielding portion 16a and the adjacent first sub-pixel 19 in the first direction X is increased, that is, the outward expansion amount of the second light-shielding portion 16a relative to the first sub-pixel 19 is increased, thereby reducing or avoiding shielding of large-view-angle light of the first sub-pixel 19 passing through the first opening 21 by the second light-shielding portion 16a, which facilitates improving WAD symmetry of the first pixel area 17.

It should be noted that due to the process limitation and influence of light-shielding requirement of the second pixel area 18, the width of the second light-shielding portion 16a generally has a lower limiting value. As such, it is not possible to further increase the outward expansion amount of the second light-shielding portion 16a relative to the first sub-pixel 19 by reducing the width of the second light-shielding portion 16a. Therefore, in a case that the width of the second light-shielding portion 16a cannot be further reduced, in some embodiments of the invention, the outward expansion amount of the second light-shielding portion 16a relative to the first sub-pixel 19 can be increased by increasing the distance between the first sub-pixel 19 and the second sub-pixel 20 adjacent to each other in the first direction X, so as to reduce or avoid the second light-shielding portion 16a from shielding the emitted light of large viewing angle of the first sub-pixel 19, thereby improving the WAD symmetry.

In some embodiments of the invention, on one hand, by providing the first light-shielding layer 15 and the second light-shielding layer 16, light of large viewing angle emitted from the first sub-pixel 19 and the second sub-pixel 20 is shielded by the first light-shielding layer 15, and light of small viewing angle emitted from the first sub-pixel 19 is not shielded by the second light-shielding layer 16, but the light of small viewing angle emitted from the second sub-pixel 20 is shielded by the second light-shielding layer 16. As such, at least in two opposite sides of the display panel 100 along the first direction X, the maximum viewing angle of emitted light of the first sub-pixel 19 through the first opening 21 is greater than the maximum viewing angle of emitted light of the second sub-pixel 20 through the second opening 22 and the third opening 23. Thus, it is possible to switch between the anti-peeping display mode and the shared display mode by controlling working states of the first sub-pixel 19 and the second sub-pixel 20.

On the other hand, the distance in the first direction X between the first sub-pixel 19 and the second sub-pixel 20 adjacent to each other in the first direction X is designed differently from the distance in the first direction X of two adjacent sub-pixels of a same type (anti-peeping or non-anti-peeping) in the first direction X, and the distance between the first sub-pixel 19 and the second sub-pixel 20 adjacent to each other in the first direction X is increased, which facilitates disposing the second light-shielding layer 16 away from the first sub-pixel 19 further, thereby reducing the shielding amount of emitted light of the first sub-pixel 19 through the first opening 21 by the second light-shielding layer 16, or preventing the emitted light of the first sub-pixel 19 through the first opening 21 from being shielded by the second light-shielding layer 16, so as to improve symmetry of viewing angles of emitted light from the first sub-pixel 19.

Therefore, embodiments of the invention can improve symmetrical performance in viewing angles of emitted light in the shared display mode on the basis of switching between the display mode and the shared display mode.

In some embodiments, the first light-shielding layer 15 and the second light-shielding layer 16 may be made of a color resist material such as black color resist material, which is not limited thereto. Certainly, at least one of the first light-shielding layer 15 and the second light-shielding layer 16 may be formed by stacking color resistors having different colors, which is not limited thereto.

In some embodiments, the distance in the first direction X between two adjacent first sub-pixels 19 in the first pixel area 17 along the first direction X is the same as the distance in the first direction X between two adjacent second sub-pixels 20 in the second pixel area 18 along the first direction X. This design is beneficial for improving the regularity of sub-pixel arrangement, thereby reducing the difficulty of the process.

In some embodiments, the distance between the first sub-pixel 19 and the second sub-pixel 20 adjacent to each other in the first direction X can be increased by reducing the width of the second sub-pixel 20 close to the first pixel area 17 in the first direction X, and/or reducing the width of the first sub-pixel 19 close to the second pixel area 18 in the first direction X. That is, the distance in the first direction X between the first sub-pixel 19 and the second sub-pixel 20 adjacent to each other in the first direction X is increased by sacrificing the area of part of the sub-pixels in the first pixel area 17 and/or the second pixel area 18.

However, since the area of the first sub-pixel 19 and the second sub-pixel 20 directly affect the life span of the pixel, the sacrificed area cannot be more than half of the area.

Specifically, the distance in the first direction X between two adjacent first sub-pixels 19 in the first direction X and/or the distance between two adjacent second sub-pixels 20 in the first direction X is d1; the distance in the first direction X between the first sub-pixel 19 and the second sub-pixel 20 adjacent to each other in the first direction X is d2; the width of the first sub-pixel 19 adjacent to (close to the first light-shielding portion 15a) the second sub-pixel 20 in the first direction X or the width of the second sub-pixel 20 adjacent to the first sub-pixel 19 in the first direction X is d3; and d1, d2 and d3 satisfy the following relationship: 0<d2-d1≤d3. The design can improve the WAD symmetry of the first pixel area 17 on the basis of ensuring the service life of the first sub-pixel 19 and/or the second sub-pixel 20.

In one specific embodiment, d1 and d2 satisfy the relationship 0<d1-d1≤15 microns (um), which is not limited thereto. For example, the width of the first sub-pixel 19 or second sub-pixel 20 adjacent to the first light-shielding portion 15a in the first direction X may be designed as 30 microns. If half of the width is sacrificed for increasing the distance between the first sub-pixel 19 and the second sub-pixel 20 adjacent to each other in the first direction X, then the actual width of the first sub-pixel 19 or second sub-pixel 20 adjacent to the first light-shielding portion 15a in the first direction X is 15 microns.

It should be noted that, the width d3 of the first sub-pixel 19 or second sub-pixel 20 in the first direction X according to some embodiments of the invention refers to the width of an effective light-emitting area of the sub-pixel in the first direction X. For example, when the first sub-pixel 19 has a section of an inverted trapezoid along the thickness direction of the substrate 1, the width of the first sub-pixel 19 in the first direction X is the width of one side of the first sub-pixel 19 close to the substrate 1 in the first direction X.

In some embodiments, a difference between maximum viewing angles of emitted light from two opposite sides of the first sub-pixel 19 adjacent to the second sub-pixel 20 in the first direction X ranges from 0° to 30°.

For example, in FIG. 2, the difference between the maximum viewing angles of emitted light from the left side of the first sub-pixel 19 adjacent to the second sub-pixel 20 along the first direction X and the maximum viewing angles of emitted light from the right side thereof is any one of or a value between any two of 0°, 5°, 10°, 15°, 20°, 25°, 30°.

It can be understood that, compared with FIG. 5, in some embodiments of the invention, the difference between maximum viewing angles of emitted light from two opposite sides of the first sub-pixel 19 in the first direction X adjacent to the second sub-pixels 20 in the first direction X is effectively reduced. In some embodiments of the embodiments, the difference between maximum viewing angles of emitted light from two opposite sides of the first sub-pixel 19 in the first direction X adjacent to the second sub-pixel 20 in the first direction X is controlled to be within a range from 0° to 30°, so that the WAD symmetry of the first pixel area 17 can be effectively improved.

It should be noted that, when the difference between the maximum viewing angles of emitted light from two opposite sides of the first sub-pixel 19 in the first direction adjacent to the second sub-pixel 20 in the first direction X is 0°, the first sub-pixel 19 adjacent to the second sub-pixel 20 in the first direction X may realize symmetrical light emission on two opposite sides in the first direction X, for example, realize symmetrical light emission on left-right side.

In some embodiments, as shown in FIG. 2, a virtual surface passing through the edge of the first light-shielding portion 15a close to the adjacent first opening 21 is defined as a reference plane S. The included angle θ between the reference plane S and the surface at one side of the first light-shielding portion 15a facing away from the substrate 1 ranges from 30° to 60°, and the second light-shielding portion 16a is located at a side of the reference plane S facing the adjacent second opening 22.
This design can ensure that the light emitted from the first sub-pixel 19 is not shielded by the second light-shielding portion 16a after passing through the first opening 21, thereby effectively improving the symmetry of the viewing angles of emitted light from the first sub-pixel 19 adjacent to the second sub-pixel 20 in the first direction X.

In some embodiments, the included angle θ between the reference plane S and the surface of the first light-shielding portion 15a facing away from the substrate 1 is 45°, but which is not limited thereto.

In some embodiments, the width of the first light-shielding portion 15a in the first direction X is greater than the width of the second light-shielding portion 16a in the first direction X. Since the first pixel area 17 and the second pixel area 18 are disposed adjacent to each other in the first direction X, the width of the first light-shielding portion 15a in the first direction X is greater than the width of the second light-shielding portion 16a in the first direction X, so that the second light-shielding portion 16a can be disposed relatively far from the first sub-pixel 19. That is, the outward expansion amount of the second light-shielding layer 16 relative to the first sub-pixel 19 may be increased, so as to prevent the second light-shielding portion 16a from shielding emitted light of the first sub-pixel 19, which facilitates improving symmetry of viewing angles of emitted light from the first sub-pixel 19.

In some embodiments, due to the process limitations, the width of each of the first light-shielding portion 15a and the second light-shielding portion 16a along the first direction X is greater than or equal to 7 microns, and less than or equal to d2.

In some embodiments, the width of each of the first light-shielding portion 15a and the second light-shielding portion 16a along the first direction X is greater than or equal to 7 microns, and less than or equal to 30 microns, but it is not limited thereto.

In some embodiments, as shown in FIG. 2, the display panel 100 further includes a pixel definition layer 2 located on the substrate 1. The pixel definition layer 2 includes a plurality of first pixel openings 11 located in the first pixel area 17, a plurality of second pixel openings 12 located in the second pixel area 18, and the blocking wall 24 disposed around the first pixel opening 11 and the second pixel opening 12. The first sub-pixel 19 is located in the first pixel opening 11, and the second sub-pixel 20 is located in the second pixel opening 12.

The blocking wall 24 includes a first blocking wall portion 24a located between the adjacent first sub-pixel 19 and second sub-pixel 20. The orthographic projection of the first light-shielding portion 15a on the substrate 1 is located in the orthographic projection of the first blocking wall portion 24a on the substrate 1, and the orthographic projection of the second light-shielding portion 16a on the substrate 1 is located in the orthographic projection of the first light-shielding portion 15a on the substrate 1.

It can be understood that the width of the first blocking wall portion 24a in the first direction X is the same as the width of the distance between the first sub-pixel 19 and second sub-pixel 20 adjacent to each other in the first direction X. Therefore, in the embodiment of the invention, the increase of the width of the distance in the first direction X between the first sub-pixel 19 and the second sub-pixel 20 adjacent to each other in the first direction X is actually an increase of the width of the first blocking wall portion 24a in the first direction X.

For example, the blocking wall 24 further includes a second blocking wall portion located between two adjacent first sub-pixels 19 and a third blocking wall portion located between two adjacent second sub-pixels 20. The width of the first blocking wall portion 24a in the first direction X is greater than the width of the second blocking wall portion and/or the third blocking wall portion in the first direction X.

It should be noted that the orthographic projection of the first light-shielding portion 15a on the substrate 1 is located in the orthographic projection of the first blocking wall portion 24a on the substrate 1, which means that the first light-shielding portion 15a and the first blocking wall portion 24a are overlapped with each other along the thickness direction Z of the substrate 1, and the width of the first light-shielding portion 15a in the first direction X is smaller than the width of the first blocking wall portion 24a in the first direction X. Similarly, the orthographic projection of the second light-shielding portion 16a on the substrate 1 is located in the orthographic projection of the first light-shielding portion 15a on the substrate 1, which means that the second light-shielding portion 16a and the first light-shielding portion 15a are overlapped with each other along the thickness direction Z of the substrate 1, and the width of the second light-shielding portion 16a in the first direction X is smaller than the width of the first light-shielding portion 15a in the first direction X. The design is beneficial to increase the viewing angles of emitted light from the first sub-pixel 19, and avoid the first light-shielding portion 15a and the second light-shielding portion 16a from shielding the emitted light of front viewing angle of the first sub-pixel 19 and the second sub-pixel 20.

In some embodiments, as shown in FIG. 2 and FIG. 3, the distance between the side of the first light-shielding portion 15a close to the adjacent first sub-pixel 19 and the side of the first blocking wall portion 24a close to the adjacent first sub-pixel 19 in the first direction X is greater than the distance between the side of the first light-shielding portion 15a close to the adjacent second sub-pixel 20 and the side of the first blocking wall portion 24a close to the adjacent second sub-pixel 20 in the first direction X. That is, the outward expansion amount of the first light-shielding portion 15a relative to the adjacent first sub-pixel 19 is greater than the outward expansion amount of the first light-shielding portion 15a relative to the adjacent second sub-pixel 20. The design is beneficial to achieve the differentiation of viewing angles of emitted light between the first sub-pixel 19 and the second sub-pixel 20, so as to achieve the anti-peeping effect. In this case, the first light-shielding portion 15a has a relatively small outward expansion amount relative to the second sub-pixel 20. This is beneficial for improving light-shielding of the first light-shielding portion 15a on the second sub-pixel 20, and preventing part of light emitted by the second sub-pixel 20 from leaking from the area between the first light-shielding portion 15a and the second light-shielding portion 16a, thereby improving stability of the anti-peeping display mode.

In some embodiments, as shown in FIG. 2 and FIG. 3, the distance between the side of the second light-shielding portion 16a close to the adjacent first sub-pixel 19 and the side of the first blocking wall portion 24a close to the adjacent first sub-pixel 19 in the first direction X is greater than the distance between the side of the second light-shielding portion 16a close to the adjacent second sub-pixel 20 and the side of the first blocking wall portion 24a close to the adjacent second sub-pixel 20 in the first direction X. That is, the outward expansion amount of the second light-shielding portion 16a relative to the adjacent first sub-pixel 19 is greater than the outward expansion amount of the second light-shielding portion 16a relative to the adjacent second sub-pixel 20. This design is beneficial in reducing or avoiding the situation that the light of large viewing angle emitted from the first sub-pixel 19 through the first opening 21 is shielded by the second light-shielding portion 16a, thereby improving the symmetry of the light emitting viewing angles of the first sub-pixel 19, that is, improving the WAD symmetry of the first pixel area 17. In this case, the second light-shielding portion 16a has a smaller outward expansion amount relative to the adjacent second sub-pixel 20. This is beneficial for reducing the viewing angles of emitted light from the second sub-pixel 20, thereby achieving good anti-peeping effect.

In some embodiments, as shown in FIG. 2 and FIG. 3, the distance between the side of the second light-shielding portion 16a close to the adjacent first sub-pixel 19 and the side of the first light-shielding portion 15a close to the adjacent first sub-pixel 19 in the first direction X is greater than the distance between the side of the second light-shielding portion 16a close to the adjacent second sub-pixel 20 and the side of the first light-shielding portion 15a close to the adjacent second sub-pixel 20 in the first direction X. That is, the second light-shielding portion 16a is disposed closer to the second sub-pixel 20 and farther away from the first sub-pixel 19. This design is beneficial in reducing or avoiding the situation that the light of large viewing angle emitted from the first sub-pixel 19 through the first opening 21 is shielded by the second light-shielding portion 16a, thereby improving the symmetry of the light emitting viewing angles of the first sub-pixel 19, that is, improving the WAD symmetry of the first pixel area 17. In this case, the second light-shielding portion 16a has a smaller outward expansion amount relative to the adjacent second sub-pixel 20. This is beneficial for reducing the viewing angles of emitted light from the second sub-pixel 20, thereby achieving good anti-peeping effect.

In some embodiments, as shown in FIG. 3, the orthographic projection of the second light-shielding portion 16a on the substrate 1 is located within the orthographic projection of the corresponding first light-shielding portion 15a on the substrate 1, and the distance between the side of the second light-shielding portion 16a close to the adjacent second sub-pixel 20 and the side of the first light-shielding portion 15a close to the adjacent second sub-pixel 20 in the first direction X is greater than 0.

In some embodiments, as shown in FIG. 4, the side of the second light-shielding portion 16a close to the adjacent second sub-pixel 20 is arranged in alignment with the side of the first light-shielding portion 15a close to the adjacent second sub-pixel 20 along the thickness direction of the substrate 1. That is, the orthographic projection of the second light-shielding portion 16a on the substrate 1 is located within the orthographic projection of the corresponding first light-shielding portion 15a on the substrate 1, and the distance between the side of the second light-shielding portion 16a close to the adjacent second sub-pixel 20 and the side of the first light-shielding portion 15a close to the adjacent second sub-pixel 20 in the first direction X is equal to 0.

Compared with the positional relationship between the second light-shielding portion 16a and the first light-shielding portion 15a shown in FIG. 3, In FIG. 4, the side of the second light-shielding portion 16a and the side of the first light-shielding portion 15a that are both close to the second sub-pixel 20 are disposed in alignment with each other in the thickness direction of the substrate 1, which is beneficial for further reducing the viewing angles of emitted light from the second sub-pixel 20, thereby achieving better anti-peeping effect.

In some embodiments, due to the process limitations, in the first direction, the distance between the side of the first light-shielding portion 15a close to the adjacent first sub-pixel 19 and the side of the first blocking wall portion 24a close to the adjacent first sub-pixel 19 is greater than or equal to 1 micron, and/or, the distance between the side of the first light-shielding portion 15a close to the adjacent second sub-pixel 20 and the side of the first blocking wall portion 24a close to the adjacent second sub-pixel 20 is greater than or equal to 1 micron; and/or, the distance between the side of the second light-shielding portion 16a close to the adjacent first sub-pixel 19 and the side of the first blocking wall portion 24a close to the adjacent first sub-pixel 19 is greater than or equal to 1 micron, and/or the distance between the side of the second light-shielding portion 16a close to the adjacent second sub-pixel 20 and the side of the first blocking wall portion 24a close to the adjacent second sub-pixel 20 is greater than or equal to 1 micron. The design can prevent the first light-shielding layer 15 and the second light-shielding layer 16 from shielding the emitted light of front viewing angle of the first sub-pixel 19 and the second sub-pixel 20, to ensure a normal display effect.

In some embodiments, as shown in FIG. 2 and FIG. 3, the orthographic projection of the first sub-pixel 19 on the substrate 1 is located within the orthographic projection of the corresponding first opening 21 on the substrate 1, and the first opening 21 includes a first sidewall 21a and a second sidewall 21b which are arranged opposite to each other along the first direction X. The distance between the orthographic projection of the first sidewall 21a on the substrate 1 and the orthographic projection of the corresponding first sub-pixel 19 on the substrate 1 in the first direction X is equal to the distance between the orthographic projection of the second sidewall 21b on the substrate 1 and the orthographic projection of the corresponding first sub-pixel 19 on the substrate 1 in the first direction X.

In some embodiments, the distance between the orthographic projection of the first sidewall 21a on the substrate 1 and the orthographic projection of the corresponding first sub-pixel 19 on the substrate 1 in the first direction X is greater than 0.

That is, the outward expansion amount of the first light-shielding layer 15 relative to the corresponding first sub-pixel 19 is greater than 0 and the outward expansion amounts on two opposite sides thereof in the first direction X relative to the corresponding first sub-pixel 19 are consistent with each other, so that the first light-shielding layer 15 can shield light of large viewing angle of the first sub-pixel 19 while achieving symmetrical light-shielding of the first sub-pixel 19 in the first direction X, thereby improving symmetry of viewing angles of emitted light from the first sub-pixel 19.

In some embodiments, as shown in FIG. 2 and FIG. 3, the orthographic projection of the second sub-pixel 20 on the substrate 1 is located within the orthographic projection of the second opening 22 on the substrate 1, and the second opening 22 includes a third sidewall 22a and a fourth sidewall 22b which are arranged opposite to each other along the first direction X. The distance between the orthographic projection of the third sidewall 22a on the substrate 1 and the orthographic projection of the corresponding second sub-pixel 20 on the substrate 1 in the first direction X is equal to the distance between the orthographic projection of the fourth sidewall 22b on the substrate 1 and the orthographic projection of the corresponding second sub-pixel 20 on the substrate 1 in the first direction X.

In some embodiments, the distance between the orthographic projection of the third sidewall 22a on the substrate 1 and the orthographic projection of the corresponding second sub-pixel 20 on the substrate 1 in the first direction X is greater than 0.

That is, the outward expansion amount of the first light-shielding layer 15 relative to the corresponding second sub-pixel 20 is greater than 0 and the outward expansion amounts on two opposite sides thereof in the first direction X relative to the corresponding second sub-pixel 20 are consistent with each other, so that the first light-shielding layer 15 can achieve symmetrical light-shielding of the second sub-pixel 20 in the first direction X, thereby improving symmetry of viewing angles of emitted light from the second sub-pixel 20.

In some embodiments, as shown in FIG. 2 and FIG. 3, the orthographic projection of the second sub-pixel 20 on the substrate 1 is located within the orthographic projection of the third opening 23 on the substrate 1, and the third opening 23 includes a fifth sidewall 23a and a sixth sidewall 23b which are arranged opposite to each other along the first direction X. The distance between the orthographic projection of the fifth sidewall 23a on the substrate 1 and the orthographic projection of the corresponding second sub-pixel 20 on the substrate 1 in the first direction X is equal to the distance between the orthographic projection of the sixth sidewall 23b on the substrate 1 and the orthographic projection of the corresponding second sub-pixel 20 on the substrate 1 in the first direction X.

In some embodiments, the distance between the orthographic projection of the fifth sidewall 23a on the substrate 1 and the orthographic projection of the corresponding second sub-pixel 20 on the substrate 1 in the first direction X is greater than 0.

That is, the outward expansion amount of the second light-shielding layer 16 relative to the corresponding second sub-pixel 20 is greater than 0 and the outward expansion amounts on two opposite sides thereof in the first direction X relative to the corresponding second sub-pixel 20 are consistent with each other, so that the second light-shielding layer 16 can achieve symmetrical light-shielding of the second sub-pixel 20 in the first direction X, thereby improving symmetry of viewing angles of emitted light from the second sub-pixel 20.

It can be understood that the range of the viewing angle for anti-peeping may be adjusted by adjusting the outward expansion amount of the first light-shielding portion 15a and the second light-shielding portion 16a with respect to the second sub-pixel 20.

In some embodiments, as shown in FIG. 3, the first light-shielding portion 15a and the second light-shielding portion 16a extend along the second direction Y, and the first direction X is perpendicular to the second direction Y.

In some embodiments, the first light-shielding portion 15a and the second light-shielding portion 16a are strip-shaped and extend along the second direction Y.

In some embodiments, as shown in FIG. 3, the first light-shielding layer 15 is provided with at least two first openings 21. The first light-shielding layer 15 further includes a third light-shielding portion 15b located between two adjacent first openings 21 along the first direction X, the third light-shielding portion 15b extends along the second direction Y, and the width of the third light-shielding portion 15b in the first direction X is smaller than the width of the first light-shielding portion 15a in the first direction X. The width of the third light-shielding portion 15b in the first direction X is relatively small, so as to reduce the area of the first light-shielding layer 15 while ensuring that the outward expansion amount of the first light-shielding layer 15 relative to the first sub-pixel 19 is large enough, which is beneficial for improving PPI of the display panel 100. In this case, the width of the first light-shielding portion 15a in the first direction X is relatively large, so as to avoid light leakage of the second sub-pixel 20 between the first light-shielding portion 15a and the second light-shielding portion 16a.

In some embodiments, as shown in FIG. 3, the first light-shielding layer 15 is provided with at least two second openings 22. The first light-shielding layer 15 further includes a fourth light-shielding portion 15c located between two adjacent second openings 22 along the first direction X, the fourth light-shielding portion 15c extends along the second direction Y, and the width of the third light-shielding portion 15b in the first direction X is smaller than the width of the fourth light-shielding portion 15c in the first direction X. Similarly, on the basis of improving PPI of the display panel 100, the design can ensure that the fourth light-shielding portion 15c has a good light-shielding effect on the second sub-pixel 20 while avoiding light leakage of the second sub-pixel 20 between the fourth light-shielding portion 15c and the second light-shielding layer 16.

In some embodiments, as shown in FIG. 3, the second light-shielding layer 16 is provided with at least two third openings 23. The second light-shielding layer 16 further includes a fifth light-shielding portion 16b located between two adjacent third openings 23 along the first direction X, the fifth light-shielding portion 16b extends along the second direction Y, and the width of the fifth light-shielding portion 16b in the first direction X is greater than the width of the second light-shielding portion 16 in the first direction X. This design can ensure that the fifth light-shielding portion 16b has a good shielding effect on light of the second sub-pixels 20 at two opposite sides of the fifth light-shielding portion in the first direction X, thereby ensuring the anti-peeping effect. In this case, the design ensures that the distance between the second light-shielding portion 16a and the adjacent first sub-pixel 19 in the first direction X is relatively large, so as to reduce or avoid the situation that the emitted light of large viewing angle of the first sub-pixel 19 is shielded by the second light-shielding portion 16a, thereby improving symmetry of the viewing angles of emitted light from the first sub-pixel 19.

In some embodiments, as shown in FIGS. 3 and 4, the light-emitting layer 14 has a plurality of first pixel areas 17 and a plurality of second pixel areas 18. In the first direction X, the first pixel areas 17 and the second pixel areas 18 are alternately arranged sequentially; and on the second direction Y perpendicular to the first direction X, the first pixel areas 17 and the second pixel areas 18 are alternately arranged sequentially. This design is beneficial to ensure that the sub-pixels in the entire display area are distributed uniformly regardless of whether it is in the anti-peeping display mode or the shared display mode, which is beneficial to improve uniformity of the display effect at various positions.

In some embodiments, as shown in FIG. 3 and FIG. 4, in the first pixel area 17 and the second pixel area 18 that are adjacent to each other in the second direction, the third light-shielding portion 15b is connected with the adjacent fourth light-shielding portion 15c in the second direction Y. The design can ensure that the first light-shielding layer 15 effectively shields the light at two opposite sides of each of the first sub-pixels 19 and each of the second sub-pixels 20 in a first direction X.

In some embodiments, as shown in FIG. 3 and FIG. 4, the fifth light-shielding portion 16b extends towards the adjacent first pixel area 17 along the second direction Y, so that the fifth light-shielding portion 16b is further located at the area between the first pixel area 17 and the second pixel area 18 adjacent to each other in the second direction Y. That is, the length of the fifth light-shielding portion 16b in the second direction Y is greater than the length of the adjacent second sub-pixel 20 in the second direction Y. Further, the fifth light-shielding portion 16b is not overlapped with the adjacent first sub-pixel 19 in the first direction X. Through this design, the light-shielding effect of the fifth light-shielding portion 16b at two opposite sides of the second sub-pixel 20 in the first direction X can be ensured without affecting the symmetrical light emission of the first sub-pixel 19. Thus, the problem of light leakage of the second sub-pixel 20 at the viewing angle (for example, viewing angle of 45° +) deviating from the first direction X is avoided.

In some embodiments, as shown in FIG. 3, two first light-shielding portions 15a adjacent to each other in the second direction Y are connected with each other, and two second light-shielding portions 16a adjacent to each other in the second direction Y are connected with each other. The design can improve the light-shielding effect of the first light-shielding layers 15 and the second light-shielding layer 16, in addition, the plurality of first light-shielding portions 15a arranged along the second direction Y can be disposed continuously, and the plurality of second light-shielding portions 16a arranged along the second direction Y can be disposed continuously, which are beneficial to reduce process difficulty.

In some embodiments, as shown in FIG. 3, the first light-shielding layer 15 further includes at least one first connecting portion 15d, and the second light-shielding layer 16 further includes at least one second connecting portion 16c. Two first light-shielding portions 15a adjacent to each other in the second direction Y are connected by one first connecting portion 15d, and two second light-shielding portions 16a adjacent to each other in the second direction Y are connected by one second connecting portion 16c. The included angle between the first connecting portion 15d and the second direction Y is greater than 0°, and the included angle between the second connecting portion 16c and the second direction Y is greater than 0°. This design can reasonably utilize the non-display area of the display panel 100, and take into account the light emission requirements of the first pixel area 17 and the second pixel area 18.

It can be understood that, since the outward expansion amount of the first light-shielding portion 15a relative to the adjacent first sub-pixel 19 is greater than the outward expansion amount of the first light-shielding portion 15a relative to the adjacent second sub-pixel 20, two adjacent first light-shielding portions 15a in the second direction Y are arranged in a staggered manner rather than being arranged along a same line. Therefore, the first connecting portion 15d between two first light-shielding portions 15a is inclined with respect to the second direction Y. Similarly, since the outward expansion amount of the second light-shielding portion 16a relative to the adjacent first sub-pixel 19 is greater than the outward expansion amount of the second light-shielding portion 16a relative to the adjacent second sub-pixel 20, two adjacent second light-shielding portions 16a in the second direction Y are arranged in a staggered manner rather than being arranged along a same line. Therefore, the second connecting portion 16c between two second light-shielding portions 16a is inclined with respect to the second direction Y.

In some embodiments, the first connecting portion 15d and the second connecting portion 16c arranged corresponding to the same area between the first sub-pixel 19 and the second sub-pixel 20 adjacent to each other are overlapped or coincident with each other in the thickness direction Z of the substrate 1.

In some embodiments, the extending direction of each of the first connecting portion 15d and the second connecting portion 16c arranged corresponding to the same area between the first sub-pixel 19 and the second sub-pixel 20 adjacent to each other is the same, which is not limited thereto.

Certainly, in other embodiments, two first light-shielding portions 15a adjacent to each other in the second direction Y may be directly connected with each other, and two second light-shielding portions 16a adjacent to each other in the second direction Y may also be directly connected with each other. The connection manner can be adjusted according to process conditions and pixel density.

In some embodiments, in the first light-shielding layer 15, any two of the first light-shielding portions 15a have a same width in the first direction X, and/or any two of the third light-shielding portions 15b have a same width in the first direction X, and/or any two of the fourth light-shielding portions 15c have a same width in the first direction X. This design facilitates the simplification of the process for manufacturing the first light-shielding layer 15.

In some embodiments, in the second light-shielding layer 16, any two of the second light-shielding portions 16a have a same width in the first direction X, and/or, any two of the fifth light-shielding portions 16b have a same width in the first direction X. This design facilitates the simplification of the process for manufacturing the second light-shielding layer 16.

It can be understood that since the first light-shielding portion 15a, the second light-shielding portion 16a, the third light-shielding portion 15b, the fourth light-shielding portion 15c and the fifth light-shielding portion 16b all extend along the second direction Y, the first opening 21, the second opening 22 and the third opening 23 also extend along the second direction Y.

In some embodiments, each of the light-shielding portions in the first light-shielding layer 15 is provided as a strip extending along the second direction Y, and each of the light-shielding portions in the second light-shielding layer 16 is provided as a strip extending along the second direction Y. In this case, the first opening 21 only includes a first sidewall 21a and a second sidewall 21b disposed opposite to each other along the first direction X, and is in an open state in the second direction Y. Similarly, the second opening 22 only includes a third sidewall 22a and a fourth sidewall 22b disposed opposite to each other along the first direction X, and is in an open state in the second direction Y. Similarly, the third opening 23 only includes a fifth sidewall 23a and a sixth sidewall 23b disposed opposite to each other along the first direction X, and is in an open state in the second direction Y.

It can be understood that, the embodiments of the invention can at least realize the anti-peeping effect on two opposite sides of the display panel 100 along the first direction X. For example, anti-peeping effect on left and right sides or upper and lower sides of the display panel 100 can be realized, but is not limited thereto.

Certainly, by adding the first light-shielding layer 15 extending along the first direction X around the first sub-pixel 19 and the second sub-pixel 20, and adding the second light-shielding layer 16 extending along the first direction X around the second sub-pixel 20, anti-peeping effect in more different orientations can be achieved. Therefore, the structures of the first light-shielding layer 15 and the second light-shielding layer 16 in the embodiments of the invention are not limited to the strip structure, and the above is merely exemplary illustration.

In some embodiments, as shown in FIG. 3 and FIG. 4, the plurality of first sub-pixels 19 in the first pixel area 17 include a first-color sub-pixel 25, a second-color sub-pixel 26 and a third-color sub-pixel 27; the plurality of second sub-pixels 20 in the second pixel area 18 include a first-color sub-pixel 25, a second-color sub-pixel 26 and a third-color sub-pixel 27.

It can be understood that the first-color sub-pixel 25 is configured to emit light of a first color, the second-color sub-pixel 26 is configured to emit light of a second color, and the third-color sub-pixel 27 is configured to emit light of a third color. The first color, the second color and the third color are different from each other.

In some embodiments, the first-color sub-pixel 25, the second-color sub-pixel 26 and the third-color sub-pixel 27 in the first pixel area 17 are arranged in a triangular pattern; and/or, the first-color sub-pixel 25, the second-color sub-pixel 26 and the third-color sub-pixel 27 in the second pixel area 18 are arranged in a triangular pattern.

In some embodiments, in the first pixel area 17 and the second pixel area 18 adjacent to each other along the first direction X, the third-color sub-pixel 27 in the first pixel area 17 is located at a side of the first-color sub-pixel 25 and the second-color sub-pixel 26 in the first pixel area 17 close to the second pixel area 18; and the third-color sub-pixel 27 in the second pixel area 18 is located at a side of the first-color sub-pixel 25 and the second-color sub-pixel 26 in the second pixel area 18 away from the first pixel area 17.

In some embodiments, as shown in FIG. 3 and FIG. 4, in any first pixel area 17 and any second pixel area 18, the first-color sub-pixel 25 and the second-color sub-pixel 26 are arranged along the second direction Y perpendicular to the first direction X, and the third-color sub-pixel 27 is arranged along the first direction X with the first-color sub-pixel 25 and/or the second-color sub-pixel 26.. In the first pixel area 17 and the second pixel area 18 adjacent to each other in the first direction X, a first-color sub-pixel 25 and/or a second-color sub-pixel 26 is disposed between two adjacent third-color sub-pixels 27.

It can be understood that in the display area of the display panel 100, the first-color sub-pixel 25 and the second-color sub-pixel 26 are arranged alternately along the second direction Y.

In some embodiments, as shown in FIG. 3 and FIG. 4, the first-color sub-pixel 25 in the first pixel area 17 and the first-color sub-pixel 25 in the second pixel area 18 are arranged along the first direction X; and the second-color sub-pixel 26 in the first pixel area 17 and the second-color sub-pixel 26 in the second pixel area 18 are arranged along the first direction X.

In some embodiments, the third-color sub-pixel 27 in the first pixel area 17 and the third-color sub-pixel 27 in the second pixel area 18 are arranged to be overlapped with each other in the first direction X, which can be partially overlapped or completely overlapped with each other.

It can be understood that, in the display area of the display panel 100, the first-color sub-pixel 25 and the third-color sub-pixel 27 are arranged alternately in sequence in the first direction X; and the second-color sub-pixel 26 and the third-color sub-pixel 27 are arranged alternately in sequence in the first direction X.

It should be noted that the alternating arrangement described in the embodiments of the invention can be arranged by being aligned along a straight line or staggered in a zigzag pattern.

In some embodiments, as shown in FIG. 3 and FIG. 4, in the same first pixel area 17, along the thickness direction of the substrate 1, the first-color sub-pixel 25 and the second-color sub-pixel 26 are arranged corresponding to the same first opening 21, and the third-color sub-pixel 27 is arranged corresponding to another first opening 21. That is to say, in the same first pixel area 17, the first-color sub-pixel 25 and the second-color sub-pixel 26 are exposed by the same first opening 21, and the third-color sub-pixel 27 is exposed by another first opening 21.

In the same second pixel area 18, along the thickness direction of the substrate 1, the first-color sub-pixel 25 and the second-color sub-pixel 26 are arranged corresponding to the same second opening 22, and the third-color sub-pixel 27 is arranged corresponding to another second opening 22. That is to say, in the same second pixel area 18, the first-color sub-pixel 25 and the second-color sub-pixel 26 are exposed by the same second opening 22, and the third-color sub-pixel 27 is exposed by another second opening 22.

Specifically, as shown in FIG. 3 and FIG. 4, the area between the third-color sub-pixel 27 in the first pixel area 17 and the first-color sub-pixel 25 and/or the second-color sub-pixel 26 in the second pixel area 18 is provided with the first light-shielding portion 15a and the second light-shielding portion 16a. That is, in the first direction X, the second sub-pixel 20 adjacent to the first pixel area 17 is the first-color sub-pixel 25 and/or the second-color sub-pixel 26 of the second pixel area 18, and the first sub-pixel 19 adjacent to the second pixel area 18 is the third-color sub-pixel 27 of the first pixel area 17.

In some embodiments, the first color is selected from any one of red, green and blue; the second color is selected from any one of red, green and blue different from the first color; and the third color is selected from red, green and blue different from both the first color and the second color.

Certainly, the first color, the second color and the third color may also be selected from other colors different from red, green and blue.

In some embodiments, the first color is green, the second color is red and the third color is blue.

It can be understood that, in the embodiments of the invention, all blue sub-pixels are disposed close to the first light-shielding portion 15a and the second light-shielding portion 16a, and the distance between the first sub-pixel 19 and the second sub-pixel 20 adjacent to each other in the first direction X can be increased by reducing the opening of the blue sub-pixel, but is not limited thereto.

In some embodiments, as shown in FIG. 2, the display panel 100 further includes an encapsulation layer 4 and a touch layer 5 disposed between the light-emitting layer 14 and the first light-shielding layer 15. The encapsulation layer 4 covers one side of the light-emitting layer 14 facing away from the substrate 1, and the touch layer 5 is disposed on one side of the encapsulation layer 4 facing away from the substrate 1.

In some embodiments, the encapsulation layer 4 includes a first inorganic encapsulation layer 4a, an organic encapsulation layer 4b and a second inorganic encapsulation layer 4c which are stacked on the light-emitting layer 14, but it is not limited thereto.

In some embodiments, the touch layer 5 includes a first touch insulation layer, a first touch metal layer, a second touch insulation layer and a second touch metal layer which are stacked on the encapsulation layer 4, but it is not limited thereto.

In some embodiments, the display panel 100 further includes at least one optical covering layer 6 disposed between the first light-shielding layer 15 and the second light-shielding layer 16. The material of the optical covering layer 6 includes a transparent optical adhesive, but is not limited thereto.

In some embodiments, the display panel 100 further includes a protective layer 8 covering the optical covering layer 6 and the second light-shielding layer 16. The material of the protective layer 8 may include an organic material but is not limited thereto.

In some embodiments, the first sub-pixel 19 and the second sub-pixel 20 are OLED devices. For example, each of the first sub-pixel 19 and the second sub-pixel 20 includes a hole injection layer, a hole transport layer, an organic light-emitting layer, an electron transport layer, an electron injection layer and a cathode layer which are stacked in corresponding pixel opening, but it is not limited thereto. In this case, the driving circuit layer of the substrate 1 further includes an anode layer. The pixel opening of the pixel definition layer 2 exposes at least part of the anode layer, and the hole injection layer is disposed on one side of the anode layer facing away from the substrate layer.

It should be noted that the diagram of the azimuth angles of the display panel 100 is shown in FIG. 6, according to FIG. 6, the display panel 100 has azimuth angles such as 0°-, 0°+, 45°-, 45°+, 90°-, 90°+, 135°-, 135°+. The first direction X in the embodiments of the invention may be a direction from 0°- to 0°+, that is, the horizontal direction. The second direction Y may be a direction from 90°- to 90°+, that is, the vertical direction.

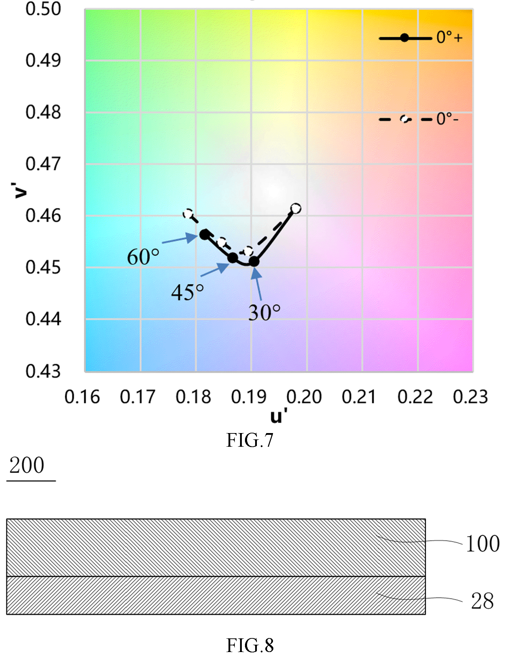

FIG. 7 is a u'v' chromaticity diagram of the first sub-pixel 19 adjacent to the second sub-pixel 20 in FIG. 5. The first sub-pixel 19 shown in FIG. 5 is a blue sub-pixel, and the second sub-pixel 20 is a red sub-pixel. FIG. 7 shows WAD trajectories of the blue sub-pixel in FIG. 5 under different viewing angles (for example, 30°, 45°, and 60°) in the 0°- direction and the 0°+ direction. The second light-shielding layer 16 shown in FIG. 5 has inconsistent light-shielding effect at the left side and right side of the first sub-pixel 19 (blue sub-pixel). In the direction of 0°-, the first sub-pixel 19 is relatively far away from the second light-shielding portion 16a, so that the light-shielding effect of the second light-shielding portion 16a is weak, such that the WAD trajectory is biased to upper-left direction (the dotted line trajectory in FIG. 7), which appears greenish yellow. In the direction of 0°+, the first sub-pixel 19 is relatively close to the second light-shielding portion 16a, so that the light shielding-effect of the second light-shielding portion 16a is strong, such that the WAD trajectory is biased to lower-right direction (the solid line trajectory in FIG. 7), which appears bluish pink, and thus, WAD symmetry of the first pixel area 17 (i.e., non-anti-peeping area) where the first sub-pixel 19 is located deteriorates.

The structure design shown in FIG. 2 is applied in the invention, so that the second light-shielding layer 16 has a consistent light-shielding effect at both the right and left sides of the first sub-pixel 19 adjacent to the second sub-pixel 20, such that the WAD trajectory in the 0⁺- direction and the WAD trajectory in the 0⁻-direction in the u'v' chromaticity diagram are coincident with each other, thereby preventing the WAD symmetry of the first pixel area 17 (i.e., non-anti-peeping area) from deteriorating.

In some embodiments of the invention, on one hand, by providing the first light-shielding layer 15 and the second light-shielding layer 16, light of large viewing angle emitted from the first sub-pixel 19 and the second sub-pixel 20 is shielded by the first light-shielding layer 15, and light of small viewing angle emitted from the first sub-pixel 19 is not shielded by the second light-shielding layer 16, but the light of small viewing angle emitted from the second sub-pixel 20 is shielded by the second light-shielding layer 16. As such, at least in two opposite sides of the display panel 100 along the first direction X, the maximum viewing angle of emitted light of the first sub-pixel 19 through the first opening 21 is greater than the maximum viewing angle of emitted light of the second sub-pixel 20 through the second opening 22 and the third opening 23. Thus, it is possible to switch between the anti-peeping display mode and the shared display mode by controlling working states of the first sub-pixel 19 and the second sub-pixel 20.

On the other hand, the distance in the first direction X between the first sub-pixel 19 and the second sub-pixel 20 adjacent to each other in the first direction X is designed differently from the distance in the first direction X of two adjacent sub-pixels of a same type (anti-peeping or non-anti-peeping) in the first direction X, and the distance between the first sub-pixel 19 and the second sub-pixel 20 adjacent to each other in the first direction X is increased, which facilitates disposing the second light-shielding layer 16 away from the first sub-pixel 19 further, thereby reducing the shielding amount of emitted light of the first sub-pixel 19 through the first opening 21 by the second light-shielding layer 16, or preventing the emitted light of the first sub-pixel 19 through the first opening 21 from being shielded by the second light-shielding layer 16, so as to improve symmetry of viewing angles of emitted light from the first sub-pixel 19. Therefore, Embodiments of the invention can improve symmetrical performance in viewing angles of emitted light from the shared display mode on the basis of switching between the display mode and the shared display mode.

As shown in FIG. 8, embodiments of the invention further provides a display device 200, and the display device 200 includes the display panel 100 in any one of the embodiments described above.

In some embodiments, the display device 200 further includes a housing 28 at least located on the back portion of the display panel 100, but it is not limited thereto.

In the embodiments of the invention, since symmetry of light emitted from the sub-pixels in the non-anti-peeping display mode (i.e., shared display mode) of the display panel 100 is improved, the display effect of the display device 200 in the non-anti-peeping display mode can be effectively enhanced.

In the description of the invention, the terms "first" and "second" are used solely for descriptive purposes and should not be understood as indicating or implying relative importance or the number of indicated technical features. Thus, features defined with "first" and "second" may explicitly or implicitly include one or more of the feature. In the description of this disclosure, the term "a plurality of" refers to two or more, unless otherwise specifically limited.

In the foregoing embodiments, the descriptions of each embodiment have their own emphasis, and for parts not described in detail in a certain embodiment, reference may be made to relevant descriptions of other embodiments. The embodiments, implementations and related technical features of the invention can be combined and replaced with each other without conflict.

What described above are only preferred embodiments of the invention and are not intended to limit the invention in any form. Any simple modification, equivalent change and embellishment to the above embodiments based on the technical essence of the invention without departing from the content of the technical solution of the invention still fall within the scope of the technical solution of the invention.

## Claims

1. A display panel (100) **characterized by** comprising:
a substrate (1);
a light-emitting layer (14) located on one side of the substrate (1) and having at least one first pixel area (17) and at least one second pixel area (18) adjacent to each other along a first direction (X); wherein the light-emitting layer (14) comprises a plurality of first sub-pixels (19) located in the first pixel area (17) and a plurality of second sub-pixels (20) located in the second pixel area (18);
a first light-shielding layer (15) located on one side of the light-emitting layer (14) facing away from the substrate (1), and provided with at least one first opening (21) and at least one second opening (22), wherein the first opening (21) is disposed corresponding to at least one of the first sub-pixels (19), and the second opening (22) is disposed corresponding to at least one of the second sub-pixels (20); and
a second light-shielding layer (16) located on one side of the first light-shielding layer (15) facing away from the substrate (1), wherein the second light-shielding layer (14) covers part of the second pixel area (18), and comprises at least one third opening (23) corresponding to the at least one second opening (22);
wherein a distance in the first direction (X) between one of the first sub-pixels (19) and one of the second sub-pixels (20) adjacent to each other in the first direction (X) is greater than at least one of a distance in the first direction (X) between two adjacent ones of the first sub-pixels (19) in the first direction and a distance in the first direction (X) between two adjacent ones of the second sub-pixels (20) in the first direction (X).

2. The display panel (100) according to claim 1, wherein the distance in the first direction (X) between the two adjacent first sub-pixels (19) in the first direction (X) and/or the distance in the first direction (X) between the two adjacent second sub-pixels (20) in the first direction (X) is d1; the distance in the first direction (X) between the first sub-pixel (19) and the second sub-pixel (20) adjacent to each other in the first direction (X) is d2; a width of one of the first sub-pixels (19) adjacent to one of the second sub-pixels (20) in the first direction (X) or a width of one of the second sub-pixels (20) adjacent to one of the first sub-pixels (19) in the first direction (X) is d3; wherein d1, d2, and d3 satisfy a relationship of d2-d1≤d3;
preferably, wherein d1 and d2 satisfy a relationship of d2-d1≤15 µm.

3. The display panel (100) according to claim 1, wherein a difference in the first direction (X) between maximum viewing angles of emitted light from two opposite sides of one of the first sub-pixels (19) adjacent to one of the second sub-pixels (20) in the first direction (X) ranges from 0° to 30°.

4. The display panel (100) according to claim 1, wherein the first light-shielding layer (15) further comprises a first light-shielding portion (15a) located between the first opening (21) and the second opening (22) adjacent to each other in the first direction (X); and the second light-shielding layer (16) further comprises a second light-shielding portion (16a) overlapped with the first light-shielding portion (15a) along a thickness direction (Z) of the substrate (1); and
wherein a virtual surface passing through an edge of the first light-shielding portion (15a) close to an adjacent first opening (21) is defined as a reference plane, an included angle between the reference plane and a surface at one side of the first light-shielding portion (15a) facing away from the substrate (1) ranges from 30° to 60°, and the second light-shielding portion (16a) is located at a side of the reference plane facing an adjacent second opening (22).

5. The display panel (100) according to any one of claims 1 to 4, wherein the first light-shielding layer (15) further comprises a first light-shielding portion (15a) located between the first opening (21) and the second opening (22) adjacent to each other in the first direction (X); and the second light-shielding layer (16) further comprises a second light-shielding portion (16a) overlapped with the first light-shielding portion (15a) along a thickness direction (Z) of the substrate (1); and
wherein a width of the first light-shielding portion (15a) in the first direction (X) is greater than a width of the second light-shielding portion (16a) in the first direction (X).

6. The display panel (100) according to claim 5, wherein the display panel (100) further comprises a pixel definition layer (2) located on the substrate (1), the pixel definition layer (2) comprises a plurality of first pixel openings located in the first pixel area (17), a plurality of second pixel openings located in the second pixel area (18), and a plurality of blocking walls (24) disposed around the first pixel openings and the second pixel openings; wherein each of the first sub-pixels (19) is located in each of the first pixel openings, and each of the second sub-pixels (20) is located in each of the second pixel openings; and
wherein one of the blocking walls (24) comprises a first blocking wall portion (24a) located between one of the first sub-pixels (19) and one of the second sub-pixels (20) adjacent to each other, an orthographic projection of the first light-shielding portion (15a) on the substrate (1) is located within an orthographic projection of the first blocking wall portion (24a) on the substrate (1), and an orthographic projection of the second light-shielding portion (16a) on the substrate (1) is located within an orthographic projection of the first light-shielding portion (15a) on the substrate (1).

7. The display panel (100) according to claim 6, wherein a distance between a side of the first light-shielding portion (15a) close to an adjacent one of the first sub-pixels (19) and a side of the first blocking wall portion (24a) close to the adjacent one of the first sub-pixels (19) in the first direction (X) is greater than a distance between a side of the first light-shielding portion (15a) close to an adjacent one of the second sub-pixels (20) and a side of the first blocking wall portion (24a) close to the adjacent one of the second sub-pixels (20) in the first direction (X); and
wherein a distance between a side of the second light-shielding portion (16a) close to an adjacent one of the first sub-pixels (19) and a side of the first blocking wall portion (24a) close to the adjacent one of the first sub-pixels (19) in the first direction (X) is greater than a distance between a side of the second light-shielding portion (16a) close to an adjacent one of the second sub-pixels (20) and a side of the first blocking wall portion (24a) close to the adjacent one of the second sub-pixels (20) in the first direction (X).

8. The display panel (100) according to claim 6, wherein a distance between a side of the second light-shielding portion (16a) close to an adjacent one of the first sub-pixels (19) and a side of the first light-shielding portion (15a) close to the adjacent one of the first sub-pixels (19) in the first direction (X) is greater than a distance between a side of the second light-shielding portion (16a) close to an adjacent one of the second sub-pixels (20) and a side of the first light-shielding portion (15a) close to the adjacent one of the second sub-pixels (20) in the first direction (X);
preferably, wherein the side of the second light-shielding portion (16a) close to the adjacent second sub-pixel (20) and the side of the first light-shielding portion (15a) close to the adjacent second sub-pixel (20) are disposed in alignment with each other in the thickness direction (Z) of the substrate (1).

9. The display panel (100) according to claim 5, wherein the first light-shielding portion (15a) and the second light-shielding portion (16a) extend along a second direction (Y), and/or, the first light-shielding portion (15a) and the second light-shielding portion (16a) are both distributed in a shape of strip along a second direction (Y); wherein the first direction (X) is perpendicular to the second direction (Y).

10. The display panel (100) according to claim 9, wherein the first light-shielding layer (15) further comprises a third light-shielding portion (15b) located between two adjacent ones of at least two first openings (21) in the first direction (X), the third light-shielding portion (15b) extends along the second direction (Y), and a width of the third light-shielding portion (15b) in the first direction (X) is smaller than the width of the first light-shielding portion (15a) in the first direction (X);
preferably, wherein the first light-shielding layer (15) further comprises a fourth light-shielding portion (15c) located between two adjacent ones of the at least two second openings (22) in the first direction (X), the fourth light-shielding portion (15c) extends along the second direction (Y), and the width of the third light-shielding portion (15b) in the first direction (X) is smaller than a width of the fourth light-shielding portion (15c) in the first direction (X).

11. The display panel (100) according to claim 9, wherein the second light-shielding layer (16) further comprises a fifth light-shielding portion (16b) located between two adjacent ones of at least two third openings (23) in the first direction (X), the fifth light-shielding portion (16b) extends along the second direction (Y), and a width of the fifth light-shielding portion (16b) in the first direction (X) is greater than the width of the second light-shielding portion (16a) in the first direction (X).

12. The display panel (100) according to claim 5, wherein the light-emitting layer (14) comprises a plurality of first pixel areas (17) and a plurality of second pixel areas (18); the first pixel areas (17) and the second pixel areas (18) are alternately arranged in the first direction (X); and the first pixel areas (17) and the second pixel areas (18) are alternately arranged in a second direction (Y) perpendicular to the first direction (X); and
wherein two first light-shielding portions (15a) disposed adjacent to each other in the second direction are connected with each other, and two second light-shielding portions (16a) disposed adjacent to each other in the second direction (Y) are connected with each other;
preferably, wherein the first light-shielding layer (15) further comprises at least one first connecting portion (15d), and the second light-shielding layer (16) further comprises at least one second connecting portion (16c); and
wherein the two first light-shielding portions (15a) adjacent to each other in the second direction (Y) are connected by one first connecting portion (15d), and the two second light-shielding portions (16a) adjacent to each other in the second direction (Y) are connected by one second connecting portion (16c), wherein an included angle between the first connecting portion (15d) and the second direction (Y) is greater than 0°, and an included angle between the second connecting portion (16c) and the second direction (Y) is greater than 0°.

13. The display panel (100) according to any one of claims 1 to 4, wherein an orthographic projection of one of the first sub-pixels (19) on the substrate (1) is located in an orthographic projection of a corresponding first opening (21) on the substrate (1), and the first opening (21) comprises a first sidewall (21a) and a second sidewall (21b) disposed opposite to each other along the first direction (X), wherein a distance between an orthographic projection of the first sidewall (21a) on the substrate (1) and an orthographic projection of a corresponding one of the first sub-pixels (19) on the substrate in the first direction (X) is equal to a distance between an orthographic projection of the second sidewall (21b) on the substrate (1) and an orthographic projection of the corresponding first sub-pixel (19) on the substrate (1) in the first direction (X); and/or
wherein an orthographic projection of one of the second sub-pixels (20) on the substrate (1) is located in an orthographic projection of the second opening (22) on the substrate (1), and the second opening (22) comprises a third sidewall (22a) and a fourth sidewall (22b) disposed opposite to each other along the first direction (X), wherein a distance between an orthographic projection of the third sidewall (22a) on the substrate (1) and an orthographic projection of a corresponding one of the second sub-pixels (20) on the substrate (1) in the first direction (X) is equal to a distance between an orthographic projection of the fourth sidewall (22b) on the substrate (1) and an orthographic projection of the corresponding second sub-pixel (20) on the substrate (1) in the first direction (X); and/or
wherein an orthographic projection of one of the second sub-pixels (20) on the substrate (1) is located in an orthographic projection of the third opening (23) on the substrate (1), and the third opening (23) comprises a fifth sidewall (23a) and a sixth sidewall (23b) disposed opposite to each other along the first direction (X), wherein a distance between an orthographic projection of the fifth sidewall (23a) on the substrate (1) and an orthographic projection of a corresponding one of the second sub-pixels (20) on the substrate (1) in the first direction (X) is equal to a distance between an orthographic projection of the sixth sidewall (23b) on the substrate (1) and an orthographic projection of the corresponding second sub-pixel (20) on the substrate (1) in the first direction (X).

14. The display panel (100) according to any one of claims 1 to 4, wherein the plurality of first sub-pixels (19) in the first pixel area (17) comprise a first-color sub-pixel (26), a second-color sub-pixel (27), and a third-color sub-pixel (28); and the plurality of second sub-pixels (20) in the second pixel area (18) comprise the first-color sub-pixel (26), the second-color sub-pixel (27), and the third-color sub-pixel (28); and
in the first pixel area (17) and the second pixel area (18) adjacent to each other along the first direction (X), the third-color sub-pixel (28) in the first pixel area (17) is located at a side of the first-color sub-pixel (26) and the second-color sub-pixel (27) in the first pixel area (17) close to the second pixel area (18); and the third-color sub-pixel (28) in the second pixel area (18) is located at a side of the first-color sub-pixel (26) and the second-color sub-pixel (27) in the second pixel area (18) away from the first pixel area (17);
preferably, wherein in a same first pixel area (17), the first-color sub-pixel (26) and the second-color sub-pixel (27) are exposed by a same one of at least two first openings (21), and the third-color sub-pixel (28) is exposed by an other one of the at least two first openings (21); and
wherein in a same second pixel area (18), the first-color sub-pixel (26) and the second-color sub-pixel (27) are exposed by a same one of at least two second openings (22), and the third-color sub-pixel (28) is exposed by an other one of the at least two second openings (22).

15. A display device (200) **characterized by** comprising the display panel (100) according to any one of claims 1 to 14.
